# EUROPÄISCHE PATENTSCHRIFT

(11) **EP 1 359 792 B1**
(45) Veröffentlichungstag und Bekanntmachung des Hinweises auf die Patenterteilung: **21.12.2005**
(21) Anmeldenummer: 03008531.0
(22) Anmeldetag: 12.04.2003
(51) Int. Cl.: H05K 1/03, B32B 15/08, C09D 5/24, C09C 1/00

(54) **Substrate mit unsichtbaren elektrisch leitfähigen Schichten**
Substrate with non-visible electrically conducting layers
Matériaux ayant des couches conductrices invisibles

(30) Priorität: 22.04.2002 AT 6152002
(43) Veröffentlichungstag der Anmeldung: 05.11.2003
(73) Patentinhaber: Hueck Folien GmbH, 4342 Baumgartenberg (AT)
(72) Erfinder: Kammerer, Hans Hermann, 92637 Weiden (DE); Kastner, Fritz, Dr., 4710 Grieskirchen (AT); Müller, Matthias, 92699 Bechtsrieth (DE); Zoister, Stefan, 4320 Perg (AT)
(74) Vertreter: Landgraf, Elvira

(56) Entgegenhaltungen:
- EP-A- 0 264 617
- EP-A- 0 450 701
- EP-A- 0 499 986
- EP-A- 0 666 704
- EP-A- 0 960 912
- WO-A-85/04780
- WO-A-99/14994
- US-A- 4 601 972
- US-A- 5 536 770
- US-A1- 2001 016 980
- US-B1- 6 293 008

## Beschreibung

Die Erfindung betrifft Substrate mit unsichtbaren elektrisch leitfähigen Schichten.

Bei der Herstellung von beschichteten Substraten werden üblicherweise elektrisch leitfähige Farben oder Lacke zum Drucken elektrisch leitfähiger Schichten verwendet. Den Farben oder Lacken werden dabei im allgemeinen leitfähige Pigmente, beispielsweise Russ, Graphit, Silber und dergleichen zugemischt. Allerdings sind die mit diesen Pigmenten versehenen Farben und Lacke nach dem Aufbringen, insbesondere auch auf transparenten Substraten deutlich sichtbar.
Bei verschiedenen Anwendungen ist es jedoch unerwünscht, dass diese elektrisch leitfähigen Schichten sofort erkennbar sind. Dies trifft insbesondere auf die Verwendung in Sicherheitsmerkmalen für Datenträger, Wertdokumente und Produkte aller Art zu.

Aus EP 0 426 801 sind beispielsweise Sicherheitselemente für Sicherheitsdokumente bekannt, die Zeichen aufweisen, die im Auflicht verborgen sind, im Durchlicht erkennbar werden und die außerdem elektrisch leitend ausgeführt sind, wobei das elektrisch leitende Material vollflächig über mindestens eine Oberfläche des Sicherheitselementes vorhanden ist und zumindest in Teilbereichen transparent oder semitransparent ausgeführt ist und über/oder unter den Zeichen angeordnet ist.
Dabei wird das transparente bzw. semitransparente Material entweder durch eine Indium-Zinn-Oxidschicht oder durch Aufsputtem einer Metallschicht, insbesondere einer Aluminiumschicht realisiert.

Aufgabe der Erfindung ist daher die Bereitstellung von Substraten mit elektrisch leitfähigen Schichten, insbesondere Strukturen, die per se nicht transparent sind, die aber unsichtbar sowohl im Auf- als auch im Durchlicht sind und eine ausreichende Leitfähigkeit zur sicheren Identifizierung und die gewünschte Funktion auch bei Vorhandensein anderer funktioneller Schichten auf dem Substrat erlauben.

Gegenstand der Erfindung sind daher Substrate mit mindestens einer elektrisch leitfähigen Schicht, dadurch gekennzeichnet, dass die elektrisch leitfähige Schicht eine mit Ruß, Graphit oder Silber pigmentierte und in Ethylenacrylatcopolymer. Nitrocellulose, PVB, PA, Acrylat oder PVC oder deren Copolymeren dispergierte Druckfarbe ist und zwischen 2 Lackschichten enthaltend bis zu 90% Metallpigmente und/oder Metallflakes und/oder Pigmente und/oder Flakes einer metallischen Verbindung unsichtbar eingebettet ist

Als elektrisch leitfähige. Schicht wird eine mit Ruß, Graphit oder Silber pigmentierte Dispersion oder Lösung in Ethylenacrylatcopolymer. Nitrocellulose, PVB, PA, Acrylat oder PVC oder deren Copolymeren verwendet. Der Pigmentanteil kann bis zu 90 % betragen, gegebenenfalls kann der Bindemittelanteil 20 - 70% betragen. Als Lösungsmittel kommen wässrige oder nicht wässrige Lösungsmittel, beispielsweise Alkohole, Alkohol/Wassermischungen, Methylethylketon, Ethylacetat und dergleichen in Frage.

Diese elektrisch leitfähige Lackschicht kann partiell oder vollflächig aufgebracht werden.

Die elektrisch leitfähige Lackschicht kann erfindungsgemäß zwischen zwei Schichten, die die pigmentierte Lackschicht vollständig abdecken, aufgebracht werden.

Da Pigmente wie Ruß oder Graphit optisch sehr deutlich sichtbar sind, muss die Zusammensetzung der Schichten, zwischen denen die leitfähige Schicht gedruckt werden soll, vollständig deckend sein.
Die elektrisch leitende Schicht kann beispielsweise auch auf einem bereits bedruckten, gefärbten oder metallisierten Trägersubstrat aufgebracht werden und anschließend mit einer deckenden Lackschicht verborgen werden, oder aber auch zwischen 2 deckenden Lackschichten aufgebracht werden.

Die deckende Lackschicht kann beispielsweise eine hochpigmentierte, vorzugsweise mit Metallpigmenten oder Metallflakes oder eine Pigmente oder Flakes von metallischen Verbindungen enthaltende Zusammensetzungen, beispielsweise eine beispielsweise Silber oder Bronzen enthaltende Zusammensetzung sein. Der Pigment- bzw. Flakesanteil kann 3 - 50% betragen. Als Bindemittel kommen beispielsweise Ethylenacrylatcopolymer, Nitrocellulose, PVB, PA, Acrylat oder PVC oder deren Copolymeren in Frage.
Die Farbschicht kann reaktiv, das heißt chemisch oder strahlungshärtend oder nicht reaktiv sein.

Gegebenenfalls kann das Trägermaterial vorher zur Verbesserung der Haftung mit einem Haftvermittler behandelt werden.

Die Aufbringung der Schichten kann auf jede bekannte konventionelle Weise erfolgen, beispielsweise durch Spin-Coating, Aufstreichen, Aufdampfen, durch Drucken, (Tiefdruck, Flexodruck, Siebdruck, Digitaldruck und dergleichen) durch Aufsprühen, Sputtem oder Walzenauftragstechniken.
Die elektrisch leitfähige Schicht und gegebenenfalls eine oder beide umgebenden Lackschichten können sowohl vollflächig als auch partiell auf dem Trägermaterial vorhanden sein.

Zur partiellen Aufbringung kann eine in einem Lösungsmittel lösliche Farbe oder ein löslicher Lack auf das Trägersubstrat oder etwaige bereits darauf befindliche Schichten aufgebracht werden. Anschließend wird die elektrisch leitfähige Lackschicht und/oder die Deckschicht auf diese Schicht aufgebracht, worauf die lösliche Farbe in den nicht beschichteten Bereichen mit Hilfe des geeigneten Lösungsmittels entfernt wird.

Als Tägersubstrate kommen beispielsweise Trägerfolien, vorzugsweise flexible transparente Kunststofffolien, beispielsweise aus Pl, PP, MOPP, PE, PPS, PEEK, PEK, PEI, PAEK, LCP, PEN, PBT, PET, PA, PC, COC, POM, ABS, PVC in Frage.
Die Trägerfolien weisen vorzugsweise eine Dicke von 5 - 700 µm, bevorzugt 8 - 200 µm, besonders bevorzugt 12 - 50 µm auf. Die Trägerfolien weisen vorzugsweise eine Dicke von 5 - 700 µm, bevorzugt 8 - 200 µm, besonders bevorzugt 12 - 50 µm auf.

Femer können als Trägersubstrat auch Metallfolien, beispielsweise AI-, Cu-, Sn-, Ni-, Fe- oder Edelstahlfolien mit einer Dicke von 5 - 200 µm, vorzugsweise 10 bis 80 µm, besonders bevorzugt 20 - 50 µm dienen. Die Folien können auch oberflächenbehandelt, beschichtet oder kaschiert beispielsweise mit Kunststoffen oder lackiert sein.

Ferner können als Trägersubstrate auch Papier oder Verbunde mit Papier, beispielsweise Verbunde mit Kunststoffen mit einem Flächengewicht von 20 - 500 g/m², vorzugsweise 40 - 200 g/m². verwendet werden.

Femer können als Trägersubstrate Gewebe oder Vliese, wie Endlosfaservliese, Stapelfaservliese und dergleichen, die gegebenenfalls vemadelt oder kalandriert sein können, verwendet werden. Vorzugsweise bestehen solche Gewebe oder Vliese aus Kunststoffen, wie PP, PET, PA, PPS und dergleichen, es können aber auch Gewebe oder Vliese aus natürlichen, gegebenenfalls behandelten Fasern, wie Viskosefasem eingesetzt werden. Die eingesetzten Vliese oder Gewebe weisen ein Flächengewicht von etwa 20 g/m² bis 500 g/m² auf. Gegebenenfalls müssen die Vliese oder Gewebe oberflächenbehandelt werden.

Das Trägersubstrat kann bereits funktionelle oder dekorative Schichten aufweisen, oder es können nach Aufbringen der leitfähigen Schicht weitere Schichten aufgebracht werden.

Die Trägersubstrate können zusätzlich eine Lackschicht aufweisen, die unstrukturiert oder strukturiert, beispielsweise geprägt sein kann. Die Lackschicht kann beispielsweise eine releasefähige Transferlackschicht sein, sie kann durch Strahlung, beispielsweise UV-Strahlung vernetzt oder vernetzbar sein und kratzfest und/oder antistatisch ausgerüstet sein. Geeignet sind sowohl wässrige als auch feste Lacksysteme, insbesondere auch Lacksysteme auf Basis Nitrocellulose, Polyester-Acrylat oder Epoxyacrylat Kolophonium-, Acrylat-, Alkyd-, Melamin-, PVA-, PVC-, Isocyanat-, Urethansysteme, die konventionell und/oder reaktiv härtend und/oder strahlungshärtend) können.

Als Farb- bzw. Lackschichten können jeweils verschiedenste Zusammensetzungen verwendet werden. Die Zusammensetzung der einzelnen Schichten kann insbesondere nach deren Aufgabe variieren, also ob die einzelnen Schichten ausschließlich Dekorationszwecken dienen oder eine funktionelle Schicht sein sollen oder ob die Schicht sowohl eine Dekorationsals auch eine funktionelle Schicht sein soll.

Diese Schichten können pigmentiert oder nicht pigmentiert sein. Als Pigmente können alle bekannten Pigmente, wie beispielsweise Titandioxid, Zinksulfid, Kaolin, ITO, ATO, FTO, Aluminium, Chrom- und Siliciumoxide als auch farbige Pigmente verwendet werden. Dabei sind lösungsmittelhaltige Lacksysteme als auch System ohne Lösungsmittel verwendbar.

Als Bindemittel kommen verschiedene natürliche oder synthetische Bindemittel in Frage.

Die weiteren funktionellen Schichten beispielsweise können bestimmte magnetische, chemische, physikalische und auch optische Eigenschaften aufweisen.

Zur Einstellung der magnetischen Eigenschaften können paramagnetische, diamagnetische und auch ferromagnetische Stoffe, wie Eisen, Nickel und Cobalt oder deren Verbindungen oder Salze (beispielsweise Oxide oder Sulfide) verwendet werden.

Besonders geeignet zur Verwendung in Verbindung mit dem erfindungsgemäßen elektrisch leitenden Schichtaufbau sind Magnetpigmentfarben mit Pigmenten auf Basis von Fe-oxiden, Eisen, Nickel Cobalt und deren Legierungen, Barium oder Cobalt-ferrite, hart- und weich magnetische Eisen- und Stahlsorten in wässrigen bzw. lösungsmittelhaltigen Dispersionen. Als Lösungsmittel kommen beispielsweise i-Propanol, Ethylacetat, Methylethylketon, Methoxypropanol und deren Mischungen in Frage.
Vorzugsweise sind die Pigmente in Acrylat- Polymerdispersionen mit einem Molekulargewicht von 150.000 bis 300.000, in Acrylat-Urethan-Dispersionen, Acrylat- Styrol oder PVC-haltigen Dispersionen oder in lösemittelhaltige derartige Dispersionen eingebracht.

Besonders vorteilhaft kann diese Magnetpigmentfarbe auch mit den elektrisch leitfähigen Zusammensetzungen oder den Deckschicht-Zusammensetzungen vermischt werden.

Die Magnetpigmentfarbe kann aber auch partiell oder vollflächig neben und/oder unter und/oder über der leitfähigen Schicht aufgebracht werden.

Die optischen Eigenschaften einer oder mehrerer weiteren Schicht(en) lassen sich durch sichtbare Farbstoffe bzw. Pigmente, lumineszierende Farbstoffe bzw. Pigmente, die im sichtbaren, im UV-Bereich oder im IR-Bereich fluoreszieren bzw. phosphoreszieren, Effektpigmente, wie Flüssigkristalle, Perlglanz, Bronzen und/oder Multilayer-Farbumschlagpigmente und wärmeempfindliche Farben bzw. Pigmente beeinflussen. Diese sind in allen möglichen Kombinationen einsetzbar. Zusätzlich können auch phosphoreszierende Pigmente allein oder in Kombination mit anderen Farbstoffen und/oder Pigmenten eingesetzt werden.

Es können auch verschiedene Eigenschaften durch Zufügen verschiedener oben genannter Zusätze kombiniert werden. So ist es möglich angefärbte und/oder leitfähige Magnetpigmente zu verwenden. Dabei sind alle genannten leitfähigen Zusätze verwendbar.
Speziell zum Anfärben von Magnetpigmenten lassen sich alle bekannten löslichen und nicht löslichen Farbstoffe bzw. Pigmente verwenden. So kann beispielsweise eine braune Magnetfarbe durch Zugabe von Metallen in ihrem Farbton metallisch, z.B. silbrig eingestellt werden.

Zum Drucken löslicher Schichten insbesondere für die partielle Aufbringung funktioneller oder dekorativer Schichten kann die verwendete Farbe bzw. der verwendete Farblack in einem Lösungsmittel, vorzugsweise in Wasser löslich sein, es kann jedoch auch eine in jedem beliebigen Lösungsmittel, beispielsweise in Alkohol, Estern und dergleichen lösliche Farbe verwendet werden. Die Farbe bzw. der Farblack können übliche Zusammensetzungen auf Basis von natürlichen oder künstlichen Makromolekülen sein. Die Farbe kann pigmentiert oder nicht pigmentiert sein. Als Pigmente können alle bekannten Pigmente verwendet werden. Besonders geeignet sind TiO₂, ZnS, Kaolin und dergleichen.

Bei Verwendung einer löslichen Farbschicht kann diese gegebenenfalls nach Aufbringung einer weiteren Schicht im erfindungsgemäßen Verfahren durch ein geeignetes Lösungsmittel, das auf die Zusammensetzung der Farbschicht abgestimmt ist, entfernt werden, um Codierungen in Form von Zeichen und/oder Mustern jeder möglichen Art herstellen zu können.

Anschließend wird die Farbschicht durch ein geeignetes Lösungsmittel, das auf die Zusammensetzung der Farbschicht abgestimmt ist, entfernt. Bevorzugt ist der Farbauftrag wasserlöslich. Gegebenenfalls kann die Ablösung durch mechanische Einwirkung unterstützt werden.

Um das Anlösen der abgedeckten Farbschicht weiter zu verbessern kann auch vollflächig oder passergenau eine dünne hochpigmentierte Farbschicht und/oder eine reine Pigmentschicht aufgebracht werden, wobei die Dicke dieser Schicht etwa 0,01 - 5 µm beträgt.

Durch das Ablösen des Farbauftrags mit den über dem Farbauftrag befindlichen Bereichen der funktionellen Schicht, wird das gewünschte Produkt erhalten.

Femer können beispielsweise Isolatorschichten aufgebracht werden. Als Isolatoren sind beispielsweise organische Substanzen und deren Derivate und Verbindungen, beispielsweise Farb- und Lacksysteme, z.B. Epoxy-, Polyester-, Kolophonium-, Acrylat-, Alkyd-, Melamin-, PVA-, PVC-, Isocyanat-, Urethansysteme, die strahlungshärtend sein können, beispielsweise durch Wärme- oder UV-Strahlung, geeignet.
Derartige Schichten können insbesondere bei der Herstellung von Multilayer-Aufbauten, beispielsweise für Leiterplatten zwischen 2 oder mehren leitfähigen Polymerschichten, die voneinander getrennt werden müssen, verwendet werden.

Diese Schichten können durch bekannte Verfahren, beispielsweise durch Bedampfen, Sputtern, Drucken (beispielsweise Tief-, Flexo-, Sieb-, Digitaldruck) und dergleichen), Sprühen, Galvanisieren und dergleichen aufgebracht werden. Die Dicke der funktionellen Schicht beträgt 0,001 bis 50 µm, vorzugsweise 0,1 bis 20 µm.

Ferner können auf dem Trägersubstrat auch zusätzliche partielle oder vollflächige metallische Schichten vorhanden sein oder anschließend aufgebracht werden.
Diese Schicht besteht aus einem Metall, einer Metallverbindung oder einer Legierung. Als Metallschicht sind Schichten aus Al, Cu, Fe, Ag, Au, Cr, Ni, Zn und dergleichen geeignet. Als Metallverbindungen sind beispielsweise Oxide oder Sulfide von Metallen, insbesondere TiO₂, Cr-Oxide, ZnS, ITO, ATO, FTO, ZnO, Al₂O₃ oder Siliciumoxide geeignet. Geeignete Legierungen sind beispielsweise Cu-AI Legierungen, Cu-Zn Legierungen und dergleichen.

Alle diese Schichten können sowohl vollflächig als auch partiell, passer- und registergenau, gegebenenfalls auch zumindest teilweise überlappend mit den bereits vorhandenen Schichten aufgebracht werden.

Werden hochpigmentierte System im Tiefdruckverfahren aufgebracht, so entstehen auf der Folie, insbesondere in Abhängigkeit vom verwendeten Rakel, unerwünschte Tonungsreste, d. h. es werden dünne Schichten außerhalb der druckenden Bereiche auf die Folie appliziert. Dadurch kann die Haftung der anschließend aufgebrachten Schichten verschlechtert werden.
Um die Entstehung derartiger Tonungsreste auf der Folie zu vermeiden, können neben der Optimierung von Rakel und Zylinderrauhigkeit auch Systeme eingesetzt werden, die diese dünnen Schichten bereits auf der Zylinderoberfläche weitgehend abtrocknen und so eine Übertragung auf die Folie verhindern.
So kann beispielsweise zwischen Rakel und Andruckwalze eine Blasleiste situiert werden, mit mehreren über die gesamte Breite angeordneten Düsen. Durch diese Düsen wird gefilterte Luft mit definierter Luftfeuchtigkeit, gegebenenfalls beheizt oder gekühlt, mit gleicher Geschwindigkeit auf den Druckzylinder gelenkt, wodurch die dünnen Schichten auf dem Zylinder abtrocknen und nicht mehr auf das Trägersubstrat appliziert werden können.
Anstelle einer derartigen Blasleiste kann auch eine über die gesamte Breite situierte IR-Trockeneinrichtung verwendet werden.

Entstandene Tonungsreste können aber auch beispielsweise durch Anwendung eines Plasma- (Niederdruck- oder Atmosphärenplasma-), Corona- oder Flammprozesses entfernt werden. Durch energiereiches Plasma, beispielsweise Ar- oder Ar/O₂-Plasma wird die Oberfläche von Tonungsresten der Druckfarben gereinigt.

Insbesondere bei der Aufbringung metallischer Schichten ist die gegebenenfalls zusätzliche Anwendung eines derartigen Prozesses vorteilhaft.
Gleichzeitig wird die dabei Oberfläche aktiviert. Dabei werden endständige polare Gruppen an der Oberfläche erzeugt. Dadurch wird die Haftung von Metallen und dergleichen an der Oberfläche verbessert.

Gegebenenfalls kann gleichzeitig mit der Anwendung der Plasma- bzw. Corona- oder Flammbehandlung eine dünne Metall- oder Metalloxidschicht als Haftvermittler, beispielsweise durch Sputtem oder Aufdampfen aufgebracht werden. Besonders geeignet sind dabei Cr, Al, Ag, Ti, Cu, TiO₂, Si-Oxide oder Chromoxide. Diese Haftvermittlenchicht weist im allgemeinen eine Dicke von 0,1 nm - 5nm, vorzugsweise 0,2 nm - 2nm, besonders bevorzugt 0,2 bis 1 nm auf.

Dadurch wird die Haftung einer weiteren partiell oder vollflächig aufgebrachten strukturierten funktionellen Schicht weiter verbessert. Das ist Voraussetzung für die Erzeugung von funktionellen Schichten mit hoher Präzision und guter Haftung.

Es können zur Sicherstellung einer einwandfreien und sicheren Funktion oder Identifizierbarkeit auch unter erschwerten mechanischen Bedingungen, beispielsweise, wenn das Substrat im Gebrauch gedehnt oder auf irgendeine andere Weise mechanisch beansprucht wird, auch vorzugsweise passergenau elektrisch leitfähige Polymerschichten aufgebracht werden. Geeignet sind vorzugsweise Polymerschichten bestehend aus Polyanilin oder Polyethylendioxythlophen. Diese Schichten weisen eine ausgezeichnete mechanische Belastbarkeit auf und sind in der Lage, mechanische Beanspruchungen entstandene Risse in der erfindungsgemäß eingebetteten anorganischen elektrisch leitfähigen Schicht zu überbrücken und so eine sichere Funktion zu überbrücken. Dabei können die Polymerschichten in Form einer Dispersion oder Lösung des Polymeren oder in Form einer Lösung des Monomeren mit einem entsprechenden Katalysator oder Initiator durch in-situ-Polymerisation aufgebracht werden. Die Aufbringung kann über und/oder unter der konventionellen elektrisch leitfähigen Schicht erfolgen.

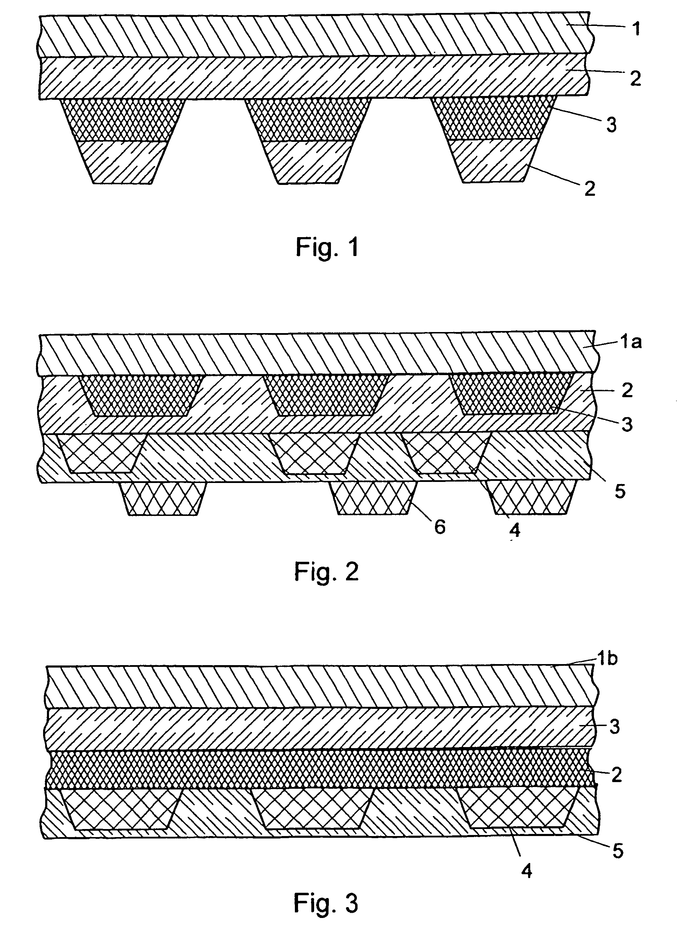

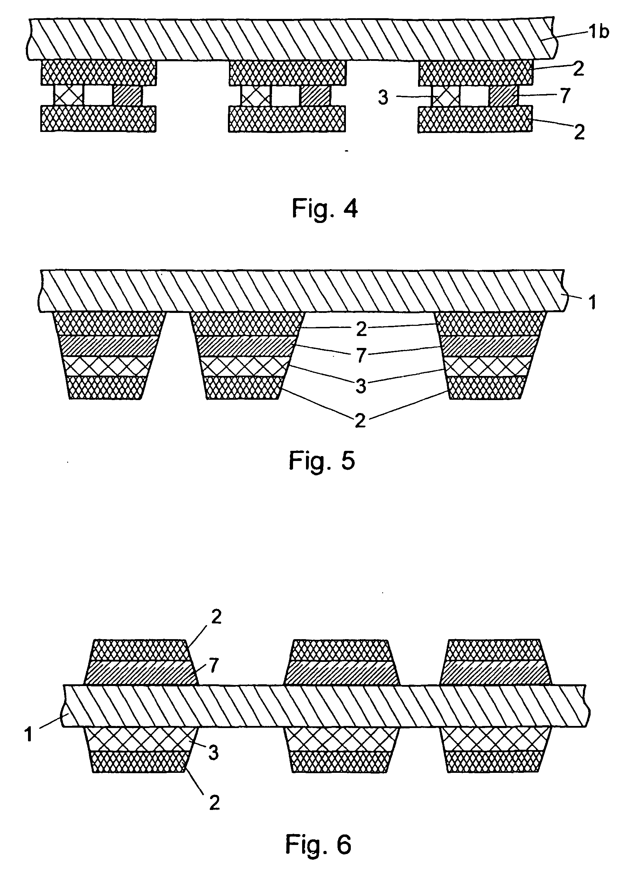

In den Figuren 1 bis 6 sind mögliche Aufbauten für unsichtbare elektrisch leitfähige Schichten dargestellt. Darin bedeuten 1 ein transparentes, 1a ein gefärbtes und 1 b ein metallisiertes Trägersubstrat, das gegebenenfalls bereits bedruckt sein kann, 2 eine Deckschicht, 3 eine elektrisch leitfähige Schicht, 4, 5 6 gegebenenfalls vorhandene weitere funktionelle und/oder dekorative Schichten und 7 eine magnetische Schicht.

Die jeweiligen Schichten können auf einer Seite oder auf beiden Seiten des Trägersubstrats vorhanden sein.
Gegebenenfalls kann das Substrat jeweils ein- oder beidseitig mit Schutzlackschichten versehen sein, oder kaschiert sein oder weiter veredelt sein, beispielsweise antistatisch oder kratzfest ausgerüstet sein.

Das Produkt ist gegebenenfalls nach entsprechender Konfektionierung daher als Sicherheitselement in Datenträgem, insbesondere Wertdokumenten wie Ausweisen, Karten, Banknoten oder Etiketten, Siegeln und dergleichen geeignet, aber auch als Verpackungsmaterial in der pharmazeutischen Industrie, beispielsweise in Form Blisterfolien, beispielsweise für Medikamente, Abdeckungen oder Verpackungen zur Unterstützung der Compliance, oder in der Lebensmittelindustrie als Lebensmittelfolie beispielsweise für Molkereiprodukte besonders geeignet. Ferner sind derartige Produkte auch für dekorative Anwendungen oder optische Elemente, beispielsweise in der Architektur und dergleichen geeignet. Besonders geeignet sind die erfindungsgemäßen Substrate zur Anwendung in der Elektronikindustrie, beispielsweise als Leiterplatten, als RF-Antennen beispielsweise für Transponder, SmartCards und dergleichen, für Displays, flexible Schaltungen, medizinische Einrichtungen, EleKtrodenaufbauten, als heizbare Folien, beispielsweise für Windschutzscheiben und dergleichen.

### Beispiele:

### Beispiel 1:

Auf einen Polyesterfolie einer Dicke von 75 µm wird eine Deckschicht bestehend aus 15% AI-Flakes in Methylketon/Ethylacetat in einer PVC/Polyesterdispersion vollflächig aufgebracht. Anschließend wird eine Schicht hochpigmentierter wasserlöslicher Farbe partiell aufgebracht. Auf diese Schicht wird eine Schicht eines elektrisch leitfähigen Lacks bestehend aus 15% Graphit in einer PVC/Polyesterdispersion aufgebracht und anschließend wieder mit der beschriebenen Deckschicht überdruckt. Nach dem Trocknen wird die hochpigmentierte Farbe und die darauf befindliche elektrisch leitfähige Schicht und die Deckschicht durch Behandlung mit Wasser abgelöst, wobei die elektrisch leitfähige Schicht und die weitere Deckschicht dann partiell auf dem Trägersubstrat verbleiben.
Anschließend wird der gesamte Aufbau mit einer konventionellen Polyurethanschutzlackschicht versehen.

## Patentansprüche

1. Substrate mit mindestens einer elektrisch leitfähigen Schicht, **dadurch gekennzeichnet, dass** die elektrisch leitfähige Schicht 4, 5, 6 eine mit Ruß, Graphit oder Silber pigmentierte und in Ethylenacrylatcopolymer. Nitrocellulose, PVB, PA, Acrylat oder PVC oder deren Copolymeren dispergierte Druckfarbe ist und zwischen 2 Lackschichten enthaltend bis zu 90% Metallpigmente und/oder Metallflakes und/oder Pigmente und/oder Flakes einer metallischen Verbindung unsichtbar eingebettet ist.

2. Substrate nach Anspruch 1, **dadurch gekennzeichnet, dass** zusätzlich weitere Farb-, Lack-, metallische Schichten und/oder Oberflächenstrukturen auf dem Substrat vorhanden sind.

3. Substrate nach einem der Ansprüche 1 oder 2, **dadurch gekennzeichnet, dass** die die elektrisch leitfähige Schicht bildende Druckfarbe mit einer Magnetpigmentfarbe bestehend aus Pigmenten auf Basis von Fe-oxiden, Eisen, Nickel Cobalt und/oder deren Legierungen, Barium- oder Cobaltferriten, hart- oder weichmagnetischen Stahlsorten in wässrigen, lösungsmittelfreien oder lösungsmittelhaltigen Dispersionen wie Nitrocellulose, Acrylat- Polymerdispersionen mit einem Molekulargewicht von 150.000 - 300.000, in Acrylat-Urethanpolymerdispersionen, Acrylat-Styrol- oder PVC-haltigen Dispersionen, vermischt ist.

4. Substrate nach einem der Ansprüche 1 bis 3, **dadurch gekennzeichnet, dass** die Magnetpigmentfarbe als getrennte Schicht partiell oder vollflächig neben und/oder über und/oder unter und oder überlappend mit der leitfähigen Schicht aufgebracht ist.

5. Verwendung der Substrate nach einem der Ansprüche 1 bis 4, gegebenenfalls nach Konfektionierung als Sicherheitselement in Datenträgem, insbesondere Wertdokumenten wie Ausweisen, Karten, Banknoten oder Etiketten, Siegeln, als Verpackungsmaterial in der pharmazeutischen und in der Lebensmittelindustrie, für dekorative Anwendungen oder optische Elemente, in der Architektur, in der Elektronikindustrie, als Leiterplatten, RF-Antennen in Transpondem und dergleichen, für Displays, flexible Schaltungen, medizinische Einrichtungen, Elektrodenaufbauten, als heizbare Folien, beispielsweise für Windschutzscheiben, als Reflexionsschichten unter Hologrammen und dergleichen.

## Claims

1. Substrates having at least one electrically conductive layer, **characterized in that** the electrically conductive layer (4, 5, 6) is a printing ink pigmented with carbon black, graphite or silver and dispersed in ethylene-acrylate copolymer, nitrocellulose, PVB, PA, acrylate or PVC or copolymers thereof and is invisibly embedded between 2 varnish layers containing up to 90% of metal pigments and/or metal flakes and/or pigments and/or flakes of a metallic compound.

2. Substrates according to Claim 1, **characterized in that** further colour layers, varnish layers, metallic layers and/or surface structures are additionally present on the substrate.

3. Substrates according to either of Claims 1 and 2, **characterized in that** the printing ink forming the electrically conductive layer has been mixed with a magnetic pigment paint composed of pigments based on Fe oxides, iron, nickel, cobalt and/or alloys thereof, barium ferrites or cobalt ferrites, hard- or soft-magnetic steel grades in aqueous, solvent-free or solvent-containing dispersions such as nitrocellulose, acrylate polymer dispersions having a molecular weight of 150 000 - 300 000, in acrylate-urethane polymer dispersions, acrylate-, styrene- or PVC-containing dispersions.

4. Substrates according to one of Claims 1 to 3, **characterized in that** the magnetic pigment paint has been applied as a separate layer partially or completely adjacent to and/or above and/or below and/or overlapping with the conductive layer.

5. Use of the substrates according to one of Claims 1 to 4, after end-use processing if appropriate, as a security element in data carriers, especially documents of value such as identity documents, cards, bank notes or labels, seals, as packaging material in the pharmaceutical and food industries, for decorative applications or optical elements, in architecture, in the electronics industry as circuit boards, RF antennas in transponders and the like, for displays, flexible circuits, medical equipment, electrode constructions, as heatable films, for example for windscreens, as reflection layers under holograms and the like.

## Revendications

1. Substrats ayant au moins une couche électriquement conductrice, **caractérisés en ce que** la couche électriquement conductrice (4, 5, 6) est une couleur d'impression pigmentée avec de la suie, du graphite ou de l'argent et dispersée dans un copolymère d'acrylate d'éthylène, de nitrocellulose, de PVB, PA, d'acrylate ou de PVC ou dans leurs copolymères et est incorporée de manière invisible entre deux couches de laque contenant jusqu'à 90 % de pigments métalliques et/ou flocons métalliques et/ou pigments et/ou flocons d'un composé métallique.

2. Substrats selon la revendication 1, **caractérisés en ce que** d'autres couches supplémentaires et/ou structures superficielles de couleur, de laque, de métal sont présentes.

3. Substrats selon l'une des revendications 1 ou 2, **caractérisés en ce que** la couleur d'impression formant la couche électriquement conductrice est mélangée avec une couleur de pigment magnétique, constituée de pigments à base d'oxydes Fe, de fer, de nickel, de cobalt et/ou de leurs alliages, de ferrites de baryum ou de cobalt, de sortes d'acier à magnétisme doux dans des dispersions contenant des solvants ou n'en contenant pas, comme la nitrocellulose, les dispersions de polymère d'acrylate ayant un poids moléculaire de 150 000 à 300 000, dans des dispersions de polymères d'acrylate - uréthane, des dispersions contenant de l'acrylate, du styrène ou du PVC.

4. Substrats selon l'une des revendications 1 à 3, **caractérisés en ce que** la couleur de pigment magnétique est déposée sous forme de couche séparée en étendue partielle ou totale à côté et/ou sur et/ou sous et/ou chevauchant la couche conductrice.

5. Utilisation des substrats selon l'une des revendications 1 à 4, le cas échéant après la confection sous forme d'élément de sécurité dans des supports de données, en particulier documents de valeur comme les papiers d'identité, les cartes, les billets de banques ou étiquettes, les sceaux, sous forme de matériau d'emballage dans l'industrie pharmaceutique et agroalimentaire, pour des applications décoratives ou des éléments optiques, en architecture, dans l'industrie électronique, sous forme de cartes de circuits imprimés, antennes RF dans des transpondeurs et similaires, pour des écrans, des circuits flexibles, des dispositifs médicaux, des structures à électrodes, sous forme de films chauffables, par exemple pour des pare-brise, sous forme de couches de réflexion, sous des hologrammes et similaires.
